(19) Europäisches Patentamt
European Patent Office
Office européen des brevets

(11) **EP 3 193 420 B1**

(12) **EUROPÄISCHE PATENTSCHRIFT**

(45) Veröffentlichungstag und Bekanntmachung des Hinweises auf die Patenterteilung:
**20.07.2022 Patentblatt 2022/29**

(21) Anmeldenummer: **16151071.4**

(22) Anmeldetag: **13.01.2016**

(51) Internationale Patentklassifikation (IPC):
**H02H 3/30** *(2006.01)* **G01R 31/08** *(2020.01)*
**H02H 7/26** *(2006.01)*

(52) Gemeinsame Patentklassifikation (CPC):
**G01R 31/085; G01R 31/11; H02H 3/30;
H02H 7/265**

(54) **VERFAHREN, EINRICHTUNG UND SYSTEM ZUM ERMITTELN DES FEHLERORTES EINES FEHLERS AUF EINER LEITUNG EINES ELEKTRISCHEN ENERGIEVERSORGUNGSNETZES**

METHOD, DEVICE AND SYSTEM FOR DETERMINING THE LOCATION A FAULT ON A LINE OF AN ELECTRICAL ENERGY SUPPLY NETWORK

PROCEDE, DISPOSITIF ET SYSTEME DESTINES A LOCALISER UN DEFAUT SUR UNE LIGNE D'UN RESEAU D'ALIMENTATION ELECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.07.2017 Patentblatt 2017/29**

(73) Patentinhaber: **Siemens Aktiengesellschaft
80333 München (DE)**

(72) Erfinder:
• **Dzienis, Cezary
14624 Dallgow-Döberitz (DE)**
• **Jurisch, Andreas
16727 Schwante (DE)**

(56) Entgegenhaltungen:
**US-A1- 2012 068 717 US-A1- 2015 081 235
US-A1- 2015 081 236**

**Beschreibung**

Die Erfindung betrifft ein Verfahren zum Ermitteln des Fehlerortes eines Fehlers auf einer Leitung eines elektrischen Energieversorgungsnetzes, bei dem an einem ersten Leitungsende der Leitung erste Strom- und Spannungswerte gemessen werden, an einem zweiten Leitungsende der Leitung zweite Strom- und Spannungswerte gemessen werden und unter Verwendung der ersten und zweiten Strom- und Spannungswerte nach dem Auftreten eines Fehlers auf der Leitung dessen Fehlerort bestimmt wird.

Die Erfindung betrifft auch eine entsprechende Einrichtung sowie ein System zum Ermitteln des Fehlerortes eines Fehlers auf einer Leitung eines elektrischen Energieversorgungsnetzes.

Der sichere Betrieb elektrischer Energieversorgungsnetze erfordert die schnelle und zuverlässige Erkennung und Abschaltung etwaiger Fehler, wie z.B. Kurzschlüssen oder Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch Inaugenscheinnahme statt. Dabei fährt das Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht. Aus der US 2012/0068717 A1 ist ein weiteres zweiseitiges Fehlerortungsverfahren bekannt, bei der der Fehler auf nicht-homogenen Leitungen durch Berechnung von Profilen der Nullsystemspannungen erfolgt.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden. Bei dem bekannten Verfahren muss jedoch eine hochgenaue zeitliche Synchronisation zwischen den Messgeräten an den beiden Leitungsenden vorliegen, damit einheitliche Zeitstempel vergeben werden können. Zur Bereitstellung eines an beiden Enden synchronen Zeitsignals sind hierbei beispielsweise Empfänger eines satellitengestützten Zeitimpulses (z.B. eines GPS-Signals) notwendig.

Ausgehend von einem Verfahren und einer Einrichtung der eingangs angegebenen Art liegt der Erfindung die Aufgabe zugrunde, eine Fehlerortung mit Messwerten von beiden Leitungsenden auch bei fehlender zeitlicher Synchronisation mit hoher Genauigkeit durchführen zu können.

Diese Aufgabe wird durch ein Verfahren nach Patentanspruch 1 gelöst. Erfindungsgemäß ist hierbei vorgesehen, dass die an den Leitungsenden gemessenen Strom- und Spannungswerte einer Filterung unterzogen werden, wobei erste und zweite gefilterte Strom- und Spannungswerte gebildet werden, die einen ausgewählten Frequenzbereich der gemessenen Strom- und Spannungswerte angeben, unter Verwendung der ersten gefilterten Strom- und Spannungswerte und eines Ausbreitungsmodells für Wanderwellen auf der Leitung ein an einem fiktiven Fehlerort auf der Leitung vorliegender zeitlicher Verlauf von ersten fiktiven Fehlerspannungswerten bestimmt wird, unter Verwendung der zweiten gefilterten Strom- und Spannungswerte und des Ausbreitungsmodells für Wanderwellen auf der Leitung ein an dem fiktiven Fehlerort auf der Leitung vorliegender zeitlicher Verlauf von zweiten fiktiven Fehlerspannungswerten bestimmt wird, ein fiktiver Fehlerort auf der Leitung ermittelt wird, für den der Verlauf der ersten fiktiven Fehlerspannungswerte mit dem Verlauf der zweiten fiktiven Fehlerspannungswerte am stärksten übereinstimmt, wobei die Ermittlung des fiktiven Fehlerortes auf der Leitung, für den der Verlauf der ersten fiktiven Fehlerspannungswerte mit dem Verlauf der zweiten fiktiven Fehlerspannungswerte am stärksten übereinstimmt, mittels eines Optimierungsverfahrens erfolgt, wobei der fiktive Fehlerort als Optimierungsgröße einer Zielfunktion des Optimierungsverfahrens verwendet wird, und der ermittelte fiktive Fehlerort als Fehlerort des Fehlers auf der Leitung verwendet wird.

Die Erfindung beruht dabei auf der Erkenntnis, dass die anhand eines Ausbreitungsmodells für Wanderwellen auf Grundlage der Messwerte von beiden Leitungsenden bestimmten Verläufe der Fehlerspannungswerte nur für den tatsächlichen Fehlerort übereinstimmen und zudem um die Propagationszeit der Wanderwelle vom Fehlerort zum jeweiligen Leitungsende verschoben sind. Mit dem Ausbreitungsmodell wird die Bewegung einer Wanderwelle entlang der elektrischen Leitung mathematisch beschrieben. Durch die Suche nach einem fiktiven Fehlerort, für den die von beiden Leitungsenden bestimmten Verläufe der Fehlerspannungswerte übereinstimmen, kann somit der tatsächliche Fehlerort mit hoher Genauigkeit bestimmt werden, ohne dass hierfür eine aufwendige zeitliche Synchronisation der Messungen an den Leitungsenden erforderlich ist.

In dieser Anmeldung werden die Ausdrücke "Fehlerort" und "Entfernung x (bzw. l-x) des Fehlerortes von einem Leitungsende" teilweise synonym verwendet und sind entsprechend zu verstehen.

Erfindungsgemäß ist vorgesehen, dass die Ermittlung des fiktiven Fehlerortes auf der Leitung, für den der Verlauf der ersten fiktiven Fehlerspannungswerte mit dem Verlauf der zweiten fiktiven Fehlerspannungswerte am stärksten übereinstimmt, mittels eines Optimierungsverfahrens erfolgt, wobei der fiktive Fehlerort als Optimierungsgröße einer Zielfunktion des Optimierungsverfahrens verwendet wird.

Hierdurch kann mit vertretbarem Rechenaufwand durch mathematische Optimierung (z.B. eine Minimierung oder eine Maximierung der Zielfunktion) der tatsächliche Fehlerort ermittelt werden.

Dabei kann das Optimierungsverfahren beispielsweise ein iteratives Optimierungsverfahren sein.

Konkret kann beispielsweise vorgesehen sein, dass mit der Zielfunktion derjenige fiktive Fehlerort bestimmt wird, für den ein Minimum der Differenz des Verlaufes der ersten fiktiven Fehlerspannungswerte und des Verlaufs der zweiten fiktiven Fehlerspannungswerte vorliegt.

Alternativ kann beispielsweise auch vorgesehen sein, dass mit der Zielfunktion derjenige fiktive Fehlerort bestimmt wird, für den ein Maximum des Produkts des Verlaufes der ersten fiktiven Fehlerspannungswerte und des konjugiert komplexen Verlaufs der zweiten fiktiven Fehlerspannungswerte vorliegt. Die Zielfunktion beschreibt in diesem Fall ein sogenanntes Kreuzleistungsspektrum, das auf die beschriebene Art und Weise im Frequenzbereich gebildet wird. Im Zeitbereich entspricht die Zielfunktion einer Kreuzkorrelation der von beiden Leitungsenden bestimmten Fehlerspannungsverläufe.

Darüber hinaus sind auch weitere Zielfunktionen denkbar, mit denen der fiktive Fehlerort ermittelt werden kann, für den die beiden Verläufe der Fehlerspannungswerte am stärksten übereinstimmen.

Außerdem ist erfindungsgemäß vorgesehen, dass die an den Leitungsenden gemessenen Strom- und Spannungswerte einer Filterung unterzogen werden, wobei erste und zweite gefilterte Strom- und Spannungswerte gebildet werden, die einen ausgewählten Frequenzbereich der gemessenen Strom- und Spannungswerte angeben, und die fiktiven ersten und zweiten Fehlerspannungswerte unter Verwendung der ersten und zweiten gefilterten Strom- und Spannungswerte bestimmt werden.

Hierbei wird das erfindungsgemäße Verfahren in vorteilhafter Weise auf das oben beschriebene Wanderwellen-Prinzip zur Fehlerortung angewendet, indem nur ausgewählte Signalanteile der Strom- und Spannungsmesswerte in einem geeigneten Frequenzbereich zur Fehlerortung herangezogen werden.

Konkret kann vorgesehen sein, dass der ausgewählte Frequenzbereich hochfrequente transiente Anteile oder bandbegrenzte transiente Anteile der gemessenen Strom- und Spannungswerte umfasst.

In diesem Zusammenhang kann zudem vorgesehen sein, dass bei einem mehrphasigen elektrischen Energieversorgungsnetz hinsichtlich der ersten und zweiten gefilterten Strom- und Spannungswerten eine mathematische Transformation zur Entkopplung der einzelnen Leitersignale durchgeführt wird, wobei erste und zweite transformierte Strom- und Spannungswerte gebildet werden, und die fiktiven ersten und zweiten Fehlerspannungswerte unter Verwendung der ersten und zweiten transformierten Strom- und Spannungswerte bestimmt werden.

Hierdurch kann das erfindungsgemäße Verfahren vorteilhaft bei - üblicherweise vorliegenden - mehrphasigen Energieversorgungsnetzen eingesetzt werden. Durch die mathematische Transformation werden die Messwerte der einzelnen Phasen entkoppelt und können einfacher ausgewertet werden. Zur Transformation kommen beispielsweise eine modale Transformation wie die Clarke-Transformation oder eine Eigenwerttransformation in Betracht.

Eine weitere vorteilhafte Ausführungsform des Erfindungsgemäßen Verfahrens sieht zudem vor, dass die Ermittlung des Fehlerortes dann vorgenommen wird, wenn im Verlauf der der ersten Strom- und Spannungswerte oder davon abgeleiteten Werten und/oder im Verlauf der zweiten Strom- und Spannungswerte oder davon abgeleiteten Werten ein Sprung festgestellt worden ist, der eine vorgegebene Schwelle übersteigt.

Auf diese Weise wird das Fehlerortungsverfahren nur bei einer sprunghaften Verlaufsänderung, wie z.B. in einem tatsächlich vorliegendem Fehlerfall, durchgeführt, weil der mit dem Fehler üblicherweise verbundene Sprung im Verlauf der Strom- und Spannungsmesswerte oder den davon abgeleiteten Werten (z.B. die oben genannten gefilterten oder transformierten Strom- und Spannungswerte) die Ausführung des Fehlerortungsverfahrens auslöst. Außerdem dient die Sprungerkennung zur korrekten Positionierung des Messfensters für die Auswertung zur Ermittlung des Fehlerortes.

Um in diesem Zusammenhang eine Unterscheidung eines tatsächlich auf der Leitung aufgetretenen Fehlerfalls von anderen Ereignissen, die sprunghafte Verlaufsänderungen bewirken, durchführen zu können, wird die mit dem Fehlerortungsverfahren ermittelte Fehlerentfernung x ausgewertet. Liegt diese Entfernung innerhalb der Leitungslänge, typisch also zwischen 0 und 1, dann ist ein Fehlerfall auf der zu überwachenden Leitung vorhanden; liegt sie hingegen außerhalb der Leitung, ist kein Fehler auf der Leitung anzunehmen.

Eine weitere vorteilhafte Ausführungsform des erfindungsgemäßen Verfahrens sieht vor, dass die Ermittlung des Fehlerortes an einem Leitungsende mittels einer dazu eingerichteten Einrichtung erfolgt, und der ermittelte Fehlerort von der Einrichtung ausgegeben wird.

Die Einrichtung kann dabei an einem der Leitungsenden vorgesehen sein oder als eine zentrale Einrichtung, z.B. eine Datenverarbeitungseinrichtung in einer Stations- oder Netzleitstelle ausgebildet sein. Der ermittelte Fehlerort kann z.B. in Prozent der Leitungslänge oder als Entfernung von einer ausgewählten Messstelle (z.B. in km oder Meilen) direkt an der Einrichtung angezeigt werden oder in Form eines Signals oder Datentelegramms ausgegeben und an einen Betreiber des Energieversorgungsnetzes übermittelt werden.

Alternativ kann auch vorgesehen sein, dass mittels je einer Einrichtung an jedem der Leitungsenden die Ermittlung des Fehlerortes erfolgt, und die mit den Einrichtungen ermittelten Fehlerorte von den Einrichtungen ausgegeben werden.

Hierbei wird die Fehlerortermittlung an beiden Leitungsenden, zwar auf Basis derselben Messwerte, aber dennoch unabhängig voneinander, vorgenommen, weshalb zwei Ergebnisse der Fehlerortermittlung erzeugt werden. Auch können in den Einrichtungen in Teilen unterschiedliche Algorithmen ausgeführt werden; beispielsweise können unterschiedliche Optimierungsverfahren eingesetzt werden. Anhand der Übereinstimmung der Ergebnisse von beiden Leitungsenden kann auf die Zuverlässigkeit des Ergebnisses geschlossen werden. Der am jeweiligen Leitungsende ermittelte Fehlerort kann z.B. in Prozent der Leitungslänge oder als Entfernung von der jeweiligen Messstelle (z.B. in km oder Meilen) direkt an der Einrichtung angezeigt werden oder in Form eines Signals oder Datentelegramms ausgegeben und an einen Betreiber des Energieversorgungsnetzes übermittelt werden.

Die oben genannte Aufgabe wird auch durch eine Einrichtung gemäß Patentanspruch 10 gelöst. Hierbei ist eine Einrichtung zum Ermitteln des Fehlerortes eines Fehlers auf einer Leitung eines elektrischen Energieversorgungsnetzes, mit einer Recheneinrichtung vorgesehen, die dazu eingerichtet ist, unter Verwendung von an einem ersten Leitungsende der Leitung gemessenen ersten Strom- und Spannungswerten und an einem zweiten Leitungsende der Leitung gemessenen zweiten Strom- und Spannungswerten nach dem Auftreten eines Fehlers auf der Leitung dessen Fehlerort zu bestimmen.

Erfindungsgemäß ist vorgesehen, dass die Einrichtung einen Filter umfasst, der dazu eingerichtet ist, die an den Leitungsenden gemessenen Strom- und Spannungswerte einer Filterung zu unterziehen, wobei erste und zweite gefilterte Strom- und Spannungswerte gebildet werden, die einen ausgewählten Frequenzbereich der gemessenen Strom- und Spannungswerte angeben, die Recheneinrichtung dazu eingerichtet ist, unter Verwendung der ersten gefilterten Strom- und Spannungswerte und eines Ausbreitungsmodells für Wanderwellen auf der Leitung einen an einem fiktiven Fehlerort auf der Leitung vorliegenden zeitlichen Verlauf von ersten fiktiven Fehlerspannungswerten und unter Verwendung der zweiten gefilterten Strom- und Spannungswerte und des Ausbreitungsmodells für Wanderwellen auf der Leitung einen an dem fiktiven Fehlerort auf der Leitung vorliegenden zeitlichen Verlauf von zweiten fiktiven Fehlerspannungswerten zu bestimmen, einen fiktiven Fehlerort auf der Leitung zu ermitteln, für den der Verlauf der ersten fiktiven Fehlerspannungswerte mit dem Verlauf der zweiten fiktiven Fehlerspannungswerte am stärksten übereinstimmt, wobei die Ermittlung des fiktiven Fehlerortes auf der Leitung, für den der Verlauf der ersten fiktiven Fehlerspannungswerte mit dem Verlauf der zweiten fiktiven Fehlerspannungswerte am stärksten übereinstimmt, mittels eines Optimierungsverfahrens erfolgt, wobei der fiktive Fehlerort als Optimierungsgröße einer Zielfunktion des Optimierungsverfahrens verwendet wird, und den ermittelten fiktiven Fehlerort als Fehlerort des Fehlers auf der Leitung anzugeben.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann gemäß einer vorteilhaften Ausführungsform der erfindungsgemäßen Einrichtung vorgesehen sein, dass die Einrichtung ein elektrisches Schutzgerät ist.

Hierbei kann die Einrichtung vorteilhaft durch ein elektrisches Schutzgerät gebildet sein, das neben der Fehlerortung noch weitere Schutz- und Überwachungsfunktionen für das elektrische Energieversorgungsnetz (z.B. eine Distanzschutzfunktion, eine Überstromschutzfunktion oder eine Differentialschutzfunktion für die Leitung) durchführt.

Alternativ dazu kann jedoch auch vorgesehen sein, dass die Einrichtung eine separate Fehlerlokalisier-Einrichtung ist. Die oben genannte Aufgabe wird außerdem auch durch ein System nach Anspruch 13 gelöst. Dieser gibt ein System zum Ermitteln des Fehlerortes eines Fehlers auf einer Leitung eines elektrischen Energieversorgungsnetzes an, bei dem erfindungsgemäß zwei nach einem der Ansprüche 10 bis 12 ausgebildeten Einrichtungen vorgesehen sind, die mit einer Kommunikationsverbindung zum Datenaustausch miteinander in Verbindung stehen.

Hinsichtlich des erfindungsgemäßen Systems gelten alle zu dem erfindungsgemäßen Verfahren und der erfindungsgemäßen Einrichtung voranstehend und nachfolgend gemachten Ausführungen und umgekehrt in entsprechender Weise. Auch hinsichtlich der Vorteile des erfindungsgemäßen Systems wird auf die zu dem erfindungsgemäßen Verfahren und der erfindungsgemäßen Einrichtung beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1      eine schematische Ansicht einer Leitung eines Energieversorgungsnetzes mit einem System zur Ermittlung eines Fehlerortes;

Figur 2      eine Darstellung der elektrischen Parameter eines Leitungsabschnitts $\Delta x$ zur Erläuterung der Bestimmung eines Fehlerortes nach dem Wanderwellenprinzip;

Figur 3      eine beispielhafte Übertragungscharakteristik eines Filters zur Erzeugung gefilterter Stromund Spannungswerte;

Figur 4      beispielhafte Verläufe von Strom- und Spannungsmesswerten;

Figur 5      beispielhafte Verläufe von gefilterten Stromund Spannungswerten;

Figur 6      beispielhafte Verläufe von aus den gefilterten Strom- und Spannungswerten erzeugten transformierten Strom- und Spannungswerten;

Figur 7      beispielhafte Verläufe von Fehlerspannungswerten bei synchronen Messungen und bekanntem Fehlerort;

Figur 8    beispielhafte Verläufe von Fehlerspannungswerten bei nicht synchronen Messungen und bekanntem Fehlerort;

Figur 9    beispielhafte Verläufe von Fehlerspannungswerten bei nicht synchronen Messungen und einem fiktiven Fehlerort, der nicht dem tatsächlichen Fehlerort entspricht;

Figur 10    beispielhafte Verläufe von Fehlerspannungswerten bei nicht synchronen Messungen und einem fiktiven Fehlerort, der dem tatsächlichen Fehlerort entspricht;

Figur 11    beispielhafte Verläufe von Zielfunktionen zur Fehlerortung; und

Figur 12    eine schematische Ansicht eines Ablaufdiagramms zur Erläuterung eines Ausführungsbeispiels eines Verfahrens zur Fehlerortung.

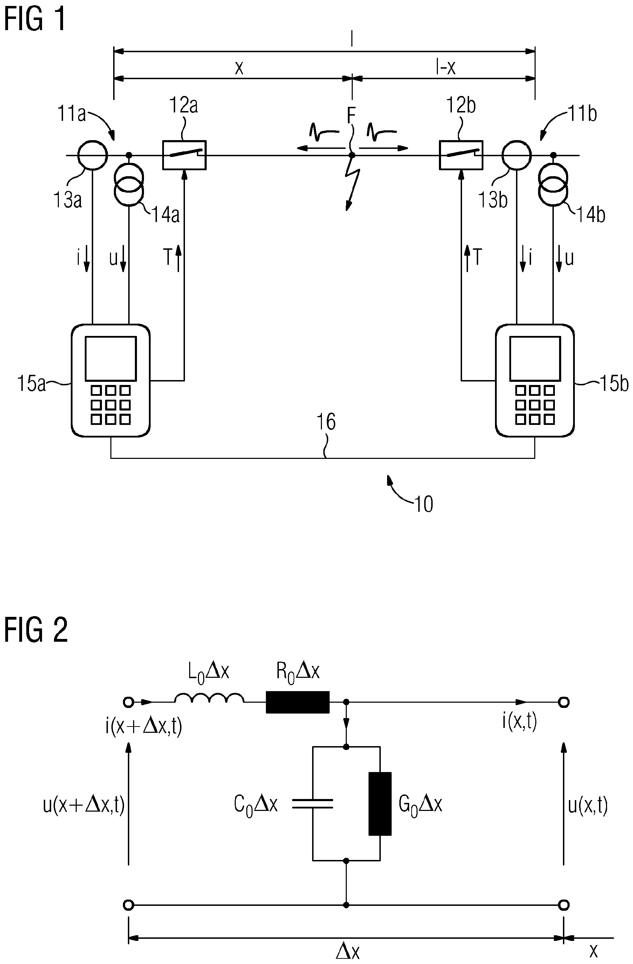

Figur 1 zeigt eine schematische Ansicht eines Systems 10 zum Ermitteln eines Fehlerortes in einem elektrischen Energieversorgungsnetz. Hierzu ist in Figur 1 eine elektrische Leitung 11 des Energieversorgungsnetzes in vereinfachter Darstellung gezeigt. Die Leitung habe die Länge l. Bei der Leitung 11 kann es sich um eine ein- oder eine mehrphasige Leitung handeln.

Die Leitung 11 wird an ihren Leitungsenden 11a und 11b durch Leistungsschalter 12a, 12b begrenzt und kann durch diese vom restlichen, in Figur 1 nicht näher dargestellten Energieversorgungsnetz abgetrennt werden. An den Leitungsenden 11a, 11b sind zudem Messstellen vorgesehen, an denen mit in Figur 1 lediglich beispielhaft dargestellten Stromwandlern 13a, 13b und Spannungswandlern 14a, 14b Strom- und Spannungsmesswerte erfasst werden. Bei den Stromwandlern 13a, 13b und den Spannungswandlern 14a, 14b kann es sich um sogenannte konventionelle oder nicht konventionelle Wandler handeln. Sekundärseitig werden von den Wandlern Strommesswerte i und Spannungsmesswerte u abgegeben, bei denen es sich um analoge oder digitalisierte Werte handeln kann.

Mit den Stromwandlern 13a, 13b und den Spannungswandlern 14a, 14b stehen an den jeweiligen Leitungsenden 11a, 11b Einrichtungen 15a, 15b zur Ermittlung eines Fehlerortes in Verbindung. Bei diesen Einrichtungen 15a, 15b kann es sich beispielsweise um elektrische Schutzgeräte handeln, die neben einer Fehlerortungsfunktion auch weitere Schutz- und Überwachungsfunktionen durchführen. Beispielsweise kann es sich bei den Schutzgeräten um Distanzschutzgeräte, Differentialschutzgeräte oder Überstromschutzgeräte handeln, die den Betriebszustand der Leitung 11 anhand der erfassten Strom- und Spannungsmesswerte überwachen und im Fehlerfall ein Ausschaltsignal T an ihren jeweiligen Leistungsschalter 12a, 12b übermitteln, um diesen zum Öffnen seiner Schaltkontakte zu veranlassen.

Die Einrichtungen 15a, 15b sind dazu eingerichtet, im Fehlerfall auf der Leitung 11 den Fehlerort, also denjenigen Ort auf der Leitung, an dem ein Fehler (z.B. Kurzschluss, Erdschluss) aufgetreten ist, zu ermitteln und auszugeben. Hierzu verwenden sie die Strom- und Spannungsmesswerte des eigenen Leitungsendes und des jeweils anderen Leitungsendes, die während des Fehlers erfasst worden sind. Zu diesem Zweck sind die Einrichtungen 15a, 15b über eine Kommunikationsverbindung 16, bei der es sich um eine beliebige geeignete drahtgebundene oder drahtlose Kommunikationsverbindung handeln kann, verbunden. Über die Kommunikationsverbindung 16 können die Einrichtungen 15a, 15b unter anderem ihre Strom- und Spannungsmesswerte zur Ermittlung des Fehlerortes austauschen.

Die Einrichtungen 15a, 15b führen eine Fehlerortung nach dem sogenannten Wanderwellenprinzip aus. Dabei wird ausgenutzt, dass beim Auftreten eines Fehlers hochfrequente transiente Signalanteile im Strom und in der Spannung entstehen, die sich etwa mit Lichtgeschwindigkeit auf der Leitung 11 in beiden Richtungen ausbreiten. Dies ist in Figur 1 beispielhaft eingezeichnet. Hierzu wird angenommen, dass an einem Fehlerort F ein Fehler aufgetreten sei. Die Wanderwellen breiten sich wie dargestellt von dem Fehlerort F sowohl in Richtung des ersten Leitungsendes 11a als auch in Richtung des zweiten Leitungsendes 11b aus und können dort mit den Wandlern messtechnisch erfasst und mit den Einrichtungen 15a, 15b zur Fehlerortbestimmung ausgewertet werden. Von dem ersten Leitungsende aus gesehen liegt der Fehlerort F in einer Entfernung x, entsprechend liegt der Fehlerort F aus Sicht des zweiten Leitungsendes in einer Entfernung l-x. Die Einrichtungen werten wie nachfolgend im Einzelnen beschrieben die Strom- und Spannungsmesswerte aus und geben den Fehlerort F, beispielsweise als Entfernung oder Prozent der Leitungslänge l aus.

Der Betreiber des Energieversorgungsnetzes kann den ermittelten Fehlerort F an ein Wartungsteam weitergeben, das daraufhin den Fehlerort aufsuchen und die Fehlerursache beheben kann. Hierzu ist eine möglichst genaue Ermittlung des Fehlerortes erforderlich. Nachfolgend wird eine Vorgehensweise zur Fehlerortung beschrieben, die im Unterschied zu bisherigen Wanderwellen-Fehlerortern ohne zeitlich synchronisierte Messwerte von den Leitungsenden 11a, 11b auskommt.

Zunächst soll eine kurze Erläuterung des Prinzips der Wanderwellen-Fehlerortung gegeben werden. Hierzu wird nachfolgend ein zweiseitiger Wanderwellen-Fehlerorter-Algorithmus erläutert, also ein Algorithmus, der mit Messwerten von beiden Leitungsenden 11a, 11b arbeitet. Dabei wird ein Ausbreitungsmodell für Wanderwellen entlang der Leitung 11 verwendet. Der bei dem erfindungsgemäßen Verfahren eingesetzte Algorithmus kommt zudem ohne zeitsynchronisierte Messwerte aus.

Zur Aufstellung des fraglichen Algorithmus wird die "Theorie der Langen Leitungen" eingesetzt. Es handelt sich hierbei um die modellhafte Abbildung einer elektrischen Leitung in Form von sogenannten "verteilten Parametern". Dies ist beispielhaft in Figur 2 dargestellt.

Der Figur 2 ist zu entnehmen, dass die Netzparameter wie Induktivitätsbelag $L_0$, Kapazitätsbelag $C_0$, Widerstandsbelag $R_0$ sowie Konduktivitätsbelag $G_0$ längs der Leitung verteilt sind. Basierend auf diesem Leitungsmodell können unter Verwendung von Kirchhoffschen-Gesetzen für das Teilstück $\Delta x$ der Leitung folgende Gleichungen für die Spannung u und den Strom i aufstellt werden:

$$u(x + \Delta x, t) = R_0 \Delta x \cdot i(x + \Delta x, t) + L_0 \Delta x \frac{\partial i(x + \Delta x, t)}{\partial t} + u(x, t) \qquad (1)$$

$$i(x + \Delta x, t) = G_0 \Delta x \cdot u(x, t) + C_0 \Delta x \frac{\partial u(x, t)}{\partial t} + i(x, t) \qquad (2)$$

Durch mathematische Umformungen lassen sich die Gleichungen (1) und (2) in die folgende Form überführen:

$$\frac{\partial u(x, t)}{\partial x} = R_0 \cdot i(x, t) + L_0 \frac{\partial i(x, t)}{\partial t} \qquad (3)$$

$$\frac{\partial i(x, t)}{\partial x} = G_0 \cdot u(x, t) + C_0 \frac{\partial u(x, t)}{\partial t} \qquad (4)$$

Diese Gleichungen (3) und (4) sind partielle Differentialgleichungen einer homogenen Leitung und werden üblicherweise als "Telegraphengleichungen" bezeichnet. Sie lassen sich auf beliebige Leiter verallgemeinern.

Durch die Betrachtung der Gleichungen (3) und (4) im Laplace-Bereich unter der Annahme von x als Parameter lassen sich viele in der Leitung entstehende Effekte wesentlich einfacher interpretieren:

$$\frac{\partial u(x, s)}{\partial x} = R_0 \cdot i(x, s) + sL_0 \cdot i(x, s) \qquad (5)$$

$$\frac{\partial i(x, s)}{\partial x} = G_0 \cdot u(x, s) + sC_0 \cdot u(x, s) \qquad (6)$$

Die Ableitung der Gleichungen (5) und (6) nach Parameter x ergibt:

$$\frac{\partial^2 u(x, s)}{\partial x^2} = Z(s)Y(s) \cdot u(x, s) \qquad (7)$$

$$\frac{\partial^2 i(x, s)}{\partial x^2} = Y(s)Z(s) \cdot i(x, s) \qquad (8)$$

Gleichungen (7) und (8) lassen sich unter Verwendung der Differentialgleichungstheorie für Spannung und Strom separat lösen:

$$U(x) = e^{-\gamma(s)x} \cdot A_1 + e^{\gamma(s)x} \cdot A_2 \qquad (9)$$

$$Z_c(s) \cdot I(x) = e^{-\gamma(s)x} \cdot A_1 - e^{\gamma(s)x} \cdot A_2 \qquad (10)$$

Bei der Lösung der Gleichungen (9) und (10) ist es möglich, die unbekannten Parameter $A_1$ und $A_2$ von den Anfangsbedingungen auszurechnen:

$$A_1 = \frac{1}{2}\left(U_1(s) + Z_c(s) \cdot I_1(s)\right) \qquad (11)$$

$$A_2 = \frac{1}{2}\left(U_1(s) - Z_c(s) \cdot I_1(s)\right) \qquad (12)$$

wobei $U_1$ und $I_1$ die Anfangsbedingungen bei x=0 darstellen. Darüber hinaus beinhalten Gleichungen (9) und (10) eine sogenannte Wellenimpedanz $Z_c$ und die Ausbreitungskonstante y, die sich aus den Leitungsparametern berechnen lassen:

$$\gamma(s)^2 = Z(s)Y(s) \qquad (13)$$

$$Z_c(s) = \gamma(s)^{-1} \cdot Z(s) \qquad (14)$$

Hierbei steht Z für die Längsimpedanz und Y für die Queradmittanz eines Abschnitts der Leitung. Die Werte werden jeweils längenbezogen angegeben.
Somit ergeben sich für die Gleichungen (9) und (10) folgende Formen:

$$U(x,s) = \frac{1}{2}e^{-\gamma(s)x} \cdot \left(U_1(s) + Z_c(s) \cdot I_1(s)\right) + \frac{1}{2}e^{\gamma(s)x} \cdot \left(U_1(s) - Z_c(s) \cdot I_1(s)\right) \qquad (15)$$

$$Z_c(s) \cdot I(x,s) = \frac{1}{2}e^{-\gamma(s)x} \cdot \left(U_1(s) + Z_c(s) \cdot I_1(s)\right) - \frac{1}{2}e^{\gamma(s)x} \cdot \left(U_1(s) - Z_c(s) \cdot I_1(s)\right) \qquad (16)$$

Gleichungen (15) und (16) stellen ein spannungs- bzw. strombezogenes Ausbreitungsmodell für Wanderwellen entlang der Leitung 11 dar. Für die vorliegend beschriebene Wanderwellen-Fehlerortung wird die Fehlerspannung an dem zunächst unbekannten Fehlerort F betrachtet. Dabei wird auf den in Gleichung (15) beschriebenen Zusammenhang zurückgegriffen.
Diese Spannungsgleichung (15) lässt sich in folgender Form im Laplace-Bereich darstellen:

$$U(x,s) = U_1(s)\cosh\gamma(s)x - Z_c(s) \cdot I_1(s)\sinh\gamma(s)x \qquad (17)$$

Der Übergang zum Frequenzbereich erfolgt durch Einsetzen von s=jω, wobei für die Kreisfrequenz steht:

$$U(x,j\omega) = U_1(j\omega)\cosh\gamma(j\omega)x - Z_c(j\omega) \cdot I_1(j\omega)\sinh\gamma(j\omega)x \qquad (18)$$

Es entsteht die analytische Gleichung (18), die für jede auftretende Frequenz f= ω/2π erfüllt ist. Aus diesem Grund kann man die Betrachtung auf ein gewähltes Frequenzspektrum begrenzen. Bei der Wanderwellen-Fehlerortung wird in einem hochfrequenten Bereich gearbeitet, in dem die Informationen über die Wanderwellenausbreitung und die auftretenden Reflektionen deutlich ausgeprägt sind.

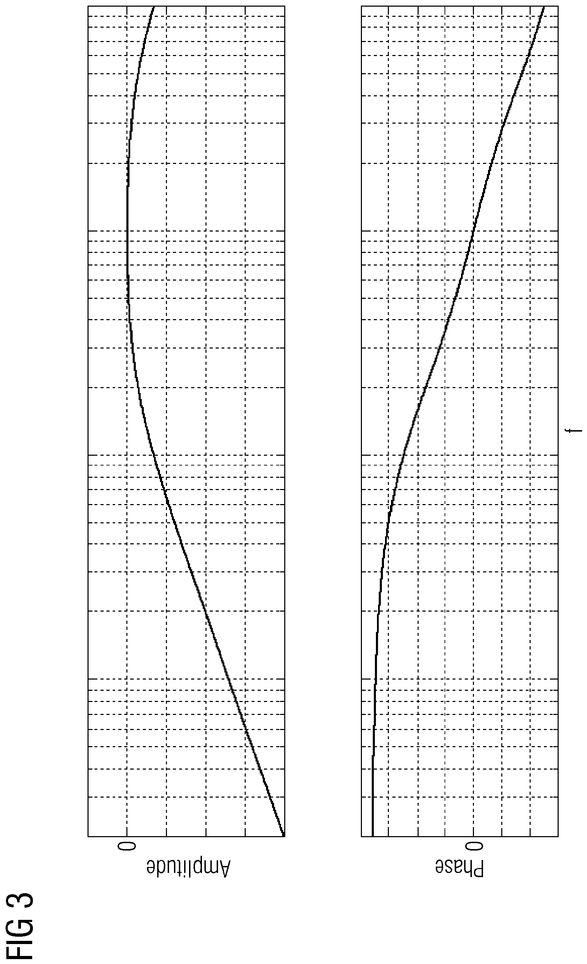

Figur 3 zeigt in diesem Zusammenhang die Übertragungsfunktion (Amplituden- und Phasengang) eines beispielhaften Filters, mit dessen Hilfe aus dem Verlauf der Strom- und Spannungsmesswerte die relevanten Frequenzen zur weiteren Analyse ausgefiltert werden, wobei gefilterte Strom- und Spannungswerte erzeugt werden. Ein beispielhafter Durchlassbereich eines geeigneten Filters kann bei etwa 30kHz bis 400kHz liegen. In diesem Bereich können üblicherweise in Energieversorgungsnetzen eingesetzte konventionelle primäre Messwandler die Signale in für die Fehlerortung ausreichender Qualität übertragen.

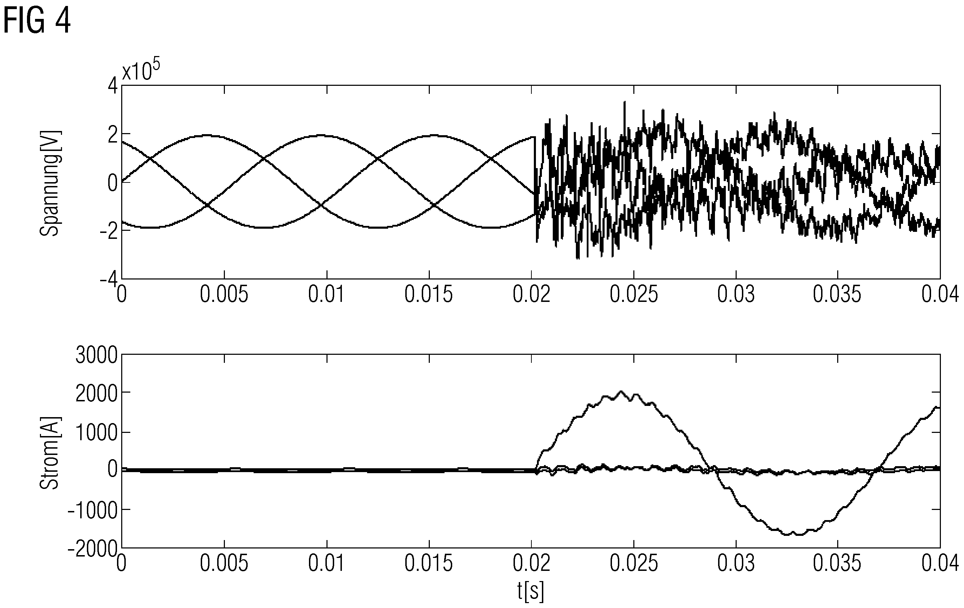

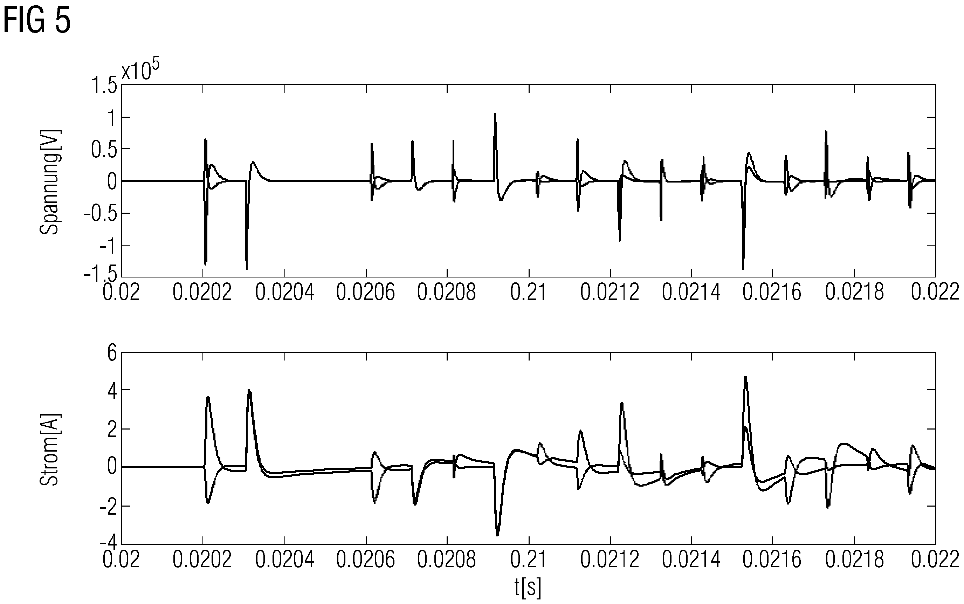

Wie sich der Filter auf die erfassten Strom- und Spannungsmesswerte auswirkt, ist in Figuren 4 und 5 beispielhaft dargestellt. Figur 4 zeigt einen beispielhaften Verlauf von Strom- und Spannungsmesswerten an einem Leitungsende einer dreiphasigen Hochspannungsleitung während eines einpoligen Fehlers in der Phase A. Der einpolige Fehler bewirkt einen Anstieg des Stromes in der fehlerbehafteten Phase A, während die Spannung in der Phase A einbricht. In den Strom- und Spannungssignalen sind nach Eintritt des Fehlers hochfrequenten Transienten enthalten, die zur Fehlerortung ausgewertet werden sollen.

Durch Verwendung eines Filters (beispielsweise eines Bandpassfilters wie im Zusammenhang mit Figur 2 beschriebenen) können die hochfrequenten transienten Anteile der Strom- und Spannungsmesswerte herausgefiltert werden. Hierdurch entstehen gefilterte Strom- und Spannungswerte wie sie in Figur 5 beispielhaft dargestellt sind. Bei der Betrachtung der gefilterten Strom- und Spannungswerte ist zu bemerken, dass die nicht-fehlerbehafteten Phasen B und C übereinstimmende hochfrequente Muster aufweisen.

Ein Fehler an dem Fehlerort F der Leitung 11 (vgl. Figur 1) führt zu einer Aufteilung der Leitung 11 in zwei Abschnitte, für die sich unter Verwendung von Gleichung (18) zwei Spannungsgleichungen (19) und (20) aufstellen lassen:

$$U_{F,1}(x, j\omega) = U_1(j\omega)\cosh\gamma(j\omega)x - Z_c(j\omega)\cdot I_1(j\omega)\sinh\gamma(j\omega)x \qquad (19)$$

$$U_{F,2}(l - x, j\omega) = U_2(j\omega)\cosh\gamma(j\omega)(l - x) - Z_c(j\omega)\cdot I_2(j\omega)\sinh\gamma(j\omega)(l - x) \quad (20)$$

Hierbei steht l für die Leitungslänge, $U_{F,1}$ für die Fehlerspannung am Fehlerort aus Sicht des ersten Leitungsendes 11a und $U_{F,2}$ für die Fehlerspannung am Fehlerort aus Sicht des zweiten Leitungsendes 11b. $U_1$, $U_2$ und $I_1$, $I_2$ stellen die gemessenen Spannungen und Ströme an den beiden Leitungsenden dar. Für den korrekten Fehlerort in Entfernung x (vom ersten Leitungsende aus gesehen) bzw. l-x (vom zweiten Leitungsende aus gesehen) sind diese beiden Spannungen gleich. Diese Bedingung wird für die Fehlerortung verwendet.

Üblicherweise umfassen die Leitungen in Energieversorgungsnetzen mindestens drei Phasenleiter. Somit ist es notwendig, die oben gegebenen Gleichungen (18) bzw. (19) und (20) in einer Matrixform zu präsentieren. Die Vereinfachung solch eines Gleichungssystems kann durch eine modale bzw. Eigenwerttransformation erfolgen. Auf diese Art und Weise wird erreicht, dass die einzelnen Gleichungen des entstehenden Gleichungssystems voneinander entkoppelt werden und somit unabhängig voneinander betrachtet werden können. Darüber hinaus ermöglicht diese Transformation, die bereits aufgestellten Gleichungen in transformierten Komponenten zu betrachten.

Beispielhaft sei nachfolgend eine einfache symmetrische Leitung betrachtet, die folgende Parameter für einen Nennfrequenz von 60Hz besitzt:

$$Z = \begin{bmatrix} 0.187 + j0.858 & 0.098 + j0.3705 & 0.098 + j0.3705 \\ 0.098 + j0.3705 & 0.187 + j0.858 & 0.098 + j0.3705 \\ 0.098 + j0.3705 & 0.098 + j0.3705 & 0.187 + j0.858 \end{bmatrix}\Omega \qquad (21)$$

$$Y = 1e - 5\begin{bmatrix} j0.3 & -j0.036 & -j0.036 \\ -j0.036 & j0.3 & -j0.036 \\ -j0.036 & -j0.036 & j0.3 \end{bmatrix}S \qquad (22)$$

Hierbei steht Z für die Leitungsimpedanz und Y für die Leitungsadmittanz. Zur Entkopplung wird als modale Transformation beispielhaft die sogenannte "Clark-Transformation" herangezogen. Diese weist eine Transformationsmatrix T wie folgt auf; es entstehen sogenannte $\alpha$-, $\beta$- und 0-Komponenten:

$$T = \frac{2}{3}\begin{bmatrix} 1 & -0.5 & -0.5 \\ 0 & \dfrac{\sqrt{3}}{2} & -\dfrac{\sqrt{3}}{2} \\ 0.5 & 0.5 & 0.5 \end{bmatrix} \qquad (23)$$

Mit der Clarke-Transformation lässt sich die oben genannten Matrizen (21) und (22) folgendermaßen transformieren:

$$Z_{\alpha\beta 0} = TZT^{-1} = \begin{bmatrix} 0.0894 + j0.487 & 0 & 0 \\ 0 & 0.0894 + j0.487 & 0 \\ 0 & 0 & 0.383 + j1.599 \end{bmatrix}\Omega \qquad (24)$$

$$Y_{\alpha\beta 0} = TYT^{-1} = 1e^{-5}\begin{bmatrix} j0.336 & 0 & 0 \\ 0 & j0.336 & 0 \\ 0 & 0 & j0.229 \end{bmatrix}S \qquad (25)$$

In Verbindung mit Gleichungen (13) und (14) ergeben sich daraus die drei zu betrachtenden Ausbreitungskonstanten (Gleichung (26))und Wellenimpedanzen (Gleichung (27)):

$$\gamma_{\alpha\beta 0} = \begin{bmatrix} 0.0001 + j0.00128 & 0 & 0 \\ 0 & 0.0001 + j0.00128 & 0 \\ 0 & 0 & 0.0002 + j0.0019 \end{bmatrix} \qquad (26)$$

$$Z_{C\alpha\beta 0} = 1e + 2\begin{bmatrix} 3.821 - j0.3475 & 0 & 0 \\ 0 & 3.821 - j0.3475 & 0 \\ 0 & 0 & 8.411 - j0.994 \end{bmatrix}\Omega \qquad (27)$$

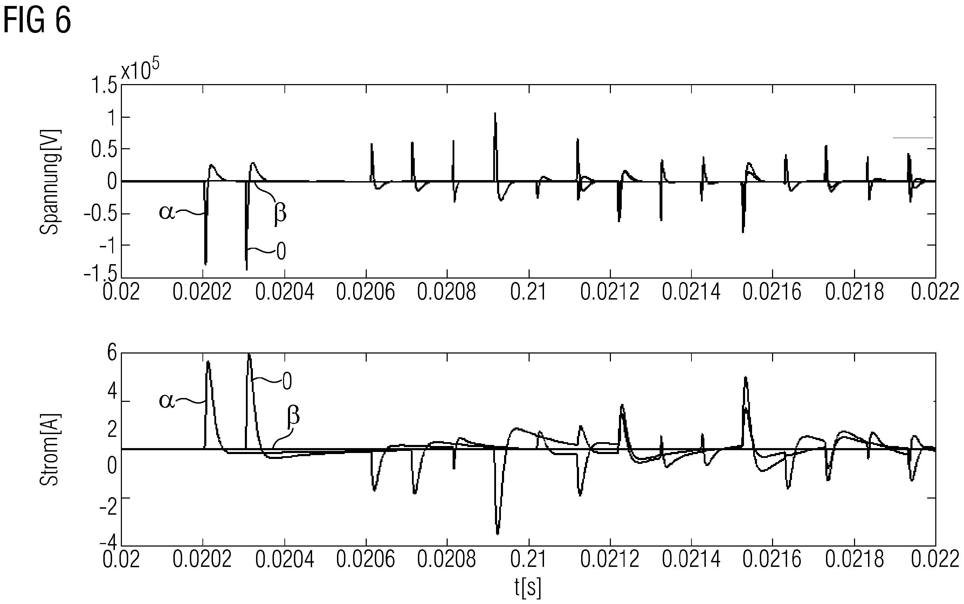

Durch die Analyse der Ausbreitungskonstante y lässt sich darauf schließen, welche der Modalen-Komponenten die größte Geschwindigkeit besitzt - diese wird bevorzugt zur weiteren Analyse verwendet. Darüber hinaus muss diejenige der Komponenten ausgewertet werden, die in einem ausreichenden Maß im Signal auftritt. Dies hängt stark von der Fehlerart ab. In Figur 6 sind die aus den gefilterten Strom- und Spannungswerten durch Transformation erzeugten transformierten Strom- und Spannungswerte dargestellt. Diese stellen die eigentlichen Wanderwellen dar, die zur Fehlerortung herangezogen werden.

Figur 6 ist zu entnehmen, dass im Beispielfall des einpoligen Fehlers in der Phase A die β-Komponente nicht auftritt. Außerdem ist zu erkennen, dass die 0-Komponente wesentlich langsamer als die α-Komponente ist.

Unter Annahme, dass der Fehlerort bekannt ist, lässt sich von beiden Leitungsenden 11a, 11b separat auf die Spannung $U_F$ an der Fehlerstelle schließen.

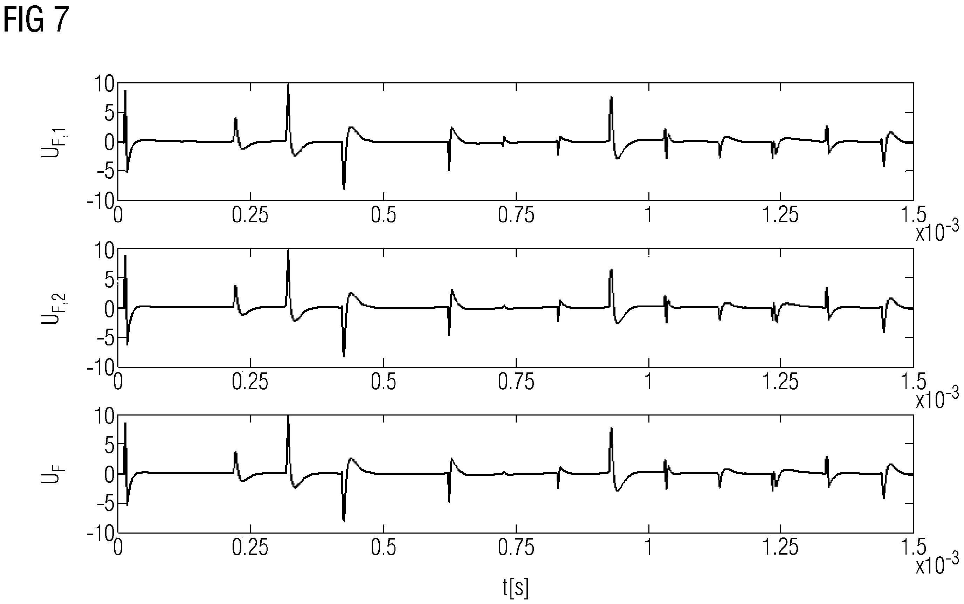

In herkömmlichen Wanderwellen-Fehlerortungssystemen findet die Messwerterfassung an beiden Leitungsenden 11a und 11b zeitlich synchronisiert statt. Die Messwerte erhalten einen Zeitstempel, mit dessen Hilfe eine exakte Zuordnung der Strom- und Spannungsmesswerte von beiden Leitungsenden stattfinden kann. Somit kann mit synchronisierter Messwerterfassung auf Basis der Gleichungen (19) und (20) eine Fehlerortung in einfacher Weise stattfinden. Dieser Fall ist in Figur 7 beispielhaft dargestellt. Man erkennt, dass am korrekten Fehlerort (Entfernung x vom ersten Leitungsende 11a) der mit den Messwerten vom ersten Leitungsende 11a bestimmte Verlauf der Fehlerspannungswerte $U_{F,1}$ mit dem mit den Messwerten vom zweiten Leitungsende 11b bestimmten Verlauf der Fehlerspannungswerte $U_{F,2}$ übereinstimmt. Zum Vergleich ist im unteren Diagramm der Figur 7 derjenige Verlauf der Fehlerspannungswerte $U_F$ angegeben, der direkt an dem Fehlerort gemessen werden könnte. Alle Verläufe der Fehlerspannungswerte sind im Beispiel der Figur 7 in dem gleichen Messfenster positioniert. Dies ist nur durch eine hochgenaue zeitliche Synchronisation möglich.

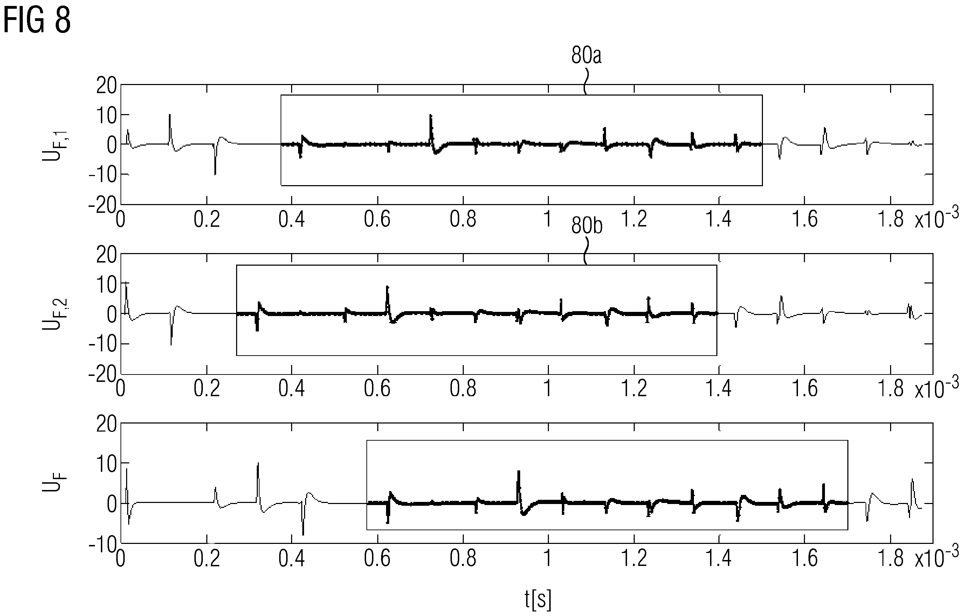

Steht keine Zeitsynchronisierung der Messwerterfassung zur Verfügung, wird sich bei bekanntem Fehlerort die Form der Kurven nicht verändern, wohl aber ihre zeitliche Zuordnung; dies ist in Figur 8 beispielhaft illustriert. In Figur 8 sind in den von den Leitungsenden 11a bzw. 11b aus bestimmten Verläufen der Fehlerspannung $U_{F,1}$, $U_{F,2}$ diejenigen Messfenster 80a, 80b mit übereinstimmenden Verläufen der Fehlerspannungswerte optisch hervorgehoben. Zum Vergleich ist auch in Figur 8 im unteren Diagramm derjenige Verlauf der Fehlerspannungswerte $U_F$ angegeben, der direkt an dem Fehlerort gemessen werden könnte. Auch in diesem Verlauf ist das entsprechend passende Messfenster 80c optisch hervorgehoben. Man erkennt, dass die in den Messfenstern 80a, 80b, 80c enthaltenen Verläufe zwar zeitlich zueinander versetzt auftreten, jedoch nahezu identische Muster aufweisen.

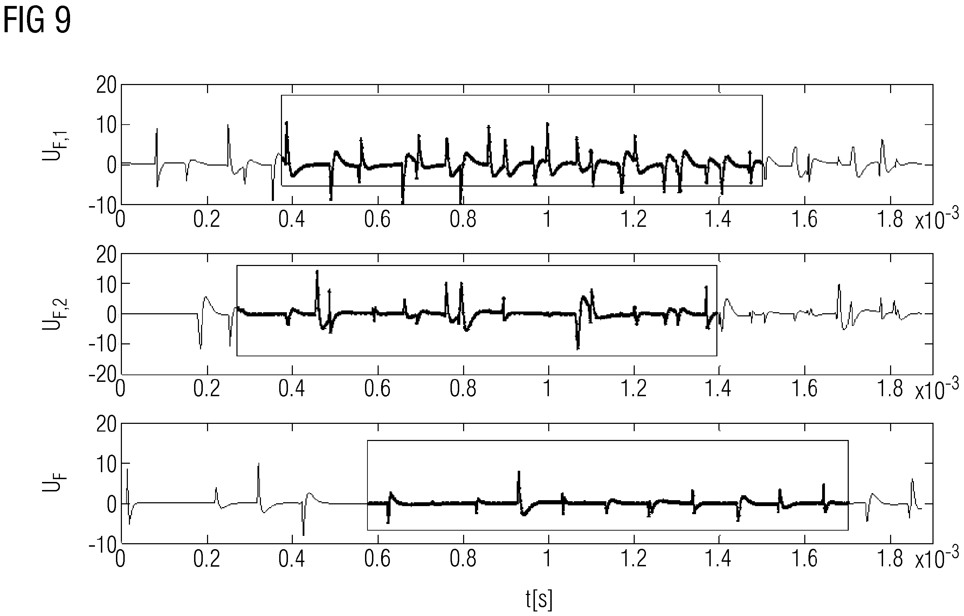

Solche nahezu identischen Muster lassen sich jedoch nur für den tatsächlichen Fehlerort bestimmen; außerhalb des tatsächlichen Fehlerortes entstehen für die Verläufe der Fehlerspannungswerte $U_{F,1}$, $U_{F,2}$ deutlich unterschiedliche Muster. Dies kann beispielhaft Figur 9 entnommen werden, in der die Fehlerspannungsverläufe $U_{F,1}$, $U_{F,2}$ für einen nicht mit dem tatsächlichen Fehlerort übereinstimmenden fiktiven Fehlerort dargestellt sind. Leicht kann in Figur 9 erkannt werden, dass die von den beiden Leitungsenden 11a, 11b aus bestimmten Fehlerspannungsverläufe $U_{F,1}$, $U_{F,2}$ innerhalb und außerhalb der für die Analyse in Figur 8 gewählten Messfenster keine übereinstimmenden Muster besitzen. Zum Vergleich ist auch in Figur 8 im unteren Diagramm derjenige Verlauf der Fehlerspannungswerte $U_F$ angegeben, der direkt an dem tatsächlichen Fehlerort gemessen werden könnte. Man erkennt auch zwischen diesem Verlauf $U_F$ und den beiden Fehlerspannungsverläufen $U_{F,1}$, $U_{F,2}$ keine Übereinstimmungen.

Diese Erkenntnis, dass es für einen tatsächlichen Fehlerort nur ein Muster gibt, das sich von den beiden Leitungsenden aus berechnet lässt und identische Muster in den jeweiligen Fehlerspannungsverläufen $U_{F,1}$, $U_{F,2}$ erzeugt, wird für die Fehlerortbestimmung nachfolgend ausgenutzt. Es muss folglich ein Fehlerort gefunden werden, für den die von beiden Leitungsenden 11a, 11b bestimmten Fehlerspannungsverläufe hinreichend genau übereinstimmen. Für eine vorhandene Messwertsynchronisation lässt sich diese Frage durch einfaches Gleichsetzen der beiden Gleichungen (19) und (20) lösen, so dass sich hieraus die Entfernung x ergibt, die den korrekten Fehlerort angibt.

Bei fehlender zeitlicher Synchronisation der Messwerterfassung wird die erforderliche Mustererkennung jedoch erschwert. Um dennoch eine Ermittlung des tatsächlichen Fehlerortes durchführen zu können, muss die Erkenntnis genutzt werden, dass eine Verschiebung der berechneten Fehlerspannungsverläufe $U_{F,1}$, $U_{F,2}$ jeweils um die Propagationszeit der Wanderwelle, d.h. derjenigen Zeit, die die Wanderwelle von dem tatsächlichen Fehlerort zum jeweiligen Leitungsende 11a, 11b benötigt, zur Erreichung der gleichen Zeitbasis führt.

Im Zeitbereich würden die sich für beide Leitungsenden ergebenden Verschiebeterme wie folgt lauten:

$$u_{F,1}(t - \frac{x}{v_{mode}}) \qquad\qquad (28)$$

für das erste Leitungsende 11a und

$$u_{F,2}(t - \frac{l-x}{v_{mode}}) \qquad\qquad (29)$$

für das zweite Leitungsende 11b. Dabei ist $v_{mode}$ die Geschwindigkeit eines jeweils ausgewählten Modes; l ist die Leitungslänge.

Im Frequenzbereich ergeben sich hieraus die entsprechenden folgenden Verschiebeterme:

$$U_{F,1}(x, j\omega)e^{-\gamma(j\omega)x} \qquad\qquad (30)$$

für das erste Leitungsende 11a und

$$U_{F,2}(x, j\omega)e^{-\gamma(j\omega)(l-x)} \qquad\qquad (31)$$

für das zweite Leitungsende 11b. Im Frequenzbereich spiegelt sich die zeitliche Verschiebung in der Multiplikation mit der komplexen Exponentialfunktion wider.

Wenn man den jeweiligen Verschiebungsterm (30) bzw. (31) auf die Gleichungen (19) bzw. (20) überträgt, ergeben sich folgende Gleichungen für die Fehlerspannungsverläufe $U_{F,1}$, $U_{F,2}$:

$$U_{F,1}(x, j\omega)e^{-\gamma(j\omega)x} = U_1(j\omega)e^{-\gamma(j\omega)x}\cosh\gamma(j\omega)x -$$
$$Z_c(j\omega)\cdot I_1(j\omega)e^{-\gamma(j\omega)x}\sinh\gamma(j\omega)x \qquad (32)$$

$$U_{F,2}(l-x, j\omega)e^{-\gamma(j\omega)(l-x)} = U_2(j\omega)e^{-\gamma(j\omega)(l-x)}\cosh\gamma(j\omega)(l-x) -$$
$$Z_c(j\omega)\cdot I_2(j\omega)e^{-\gamma(j\omega)(l-x)}\sinh\gamma(j\omega)(l-x) \qquad (33)$$

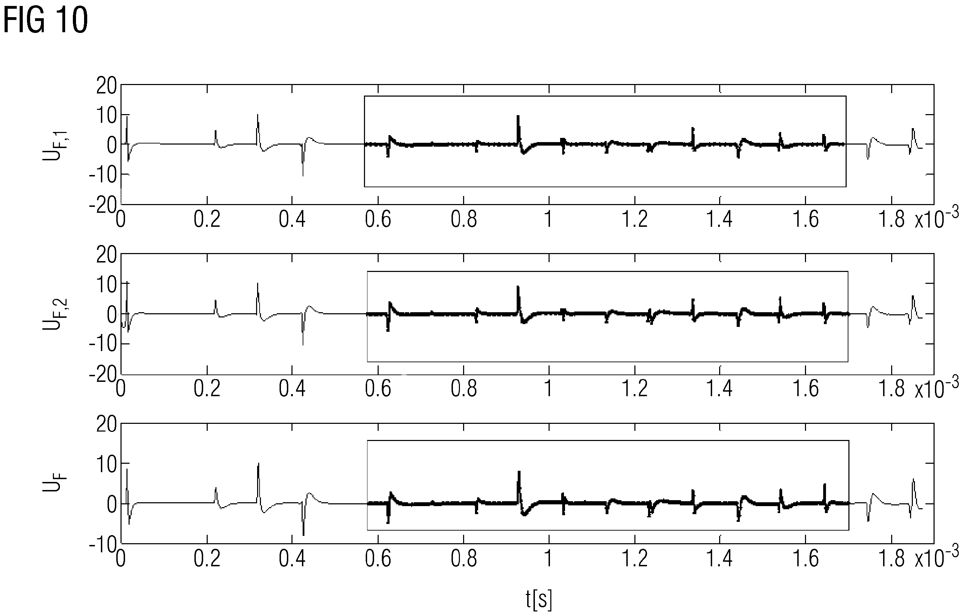

Das Ergebnis dieser zeitlichen Verschiebung ist beispielhaft Figur 10 für einen bekannten tatsächlichen Fehlerort zu entnehmen; hier wurden durch die Verschiebung alle die Spannungskurven bzw. Messfenster auf die gleiche Zeitbasis umgerechnet. Zum Vergleich ist auch in Figur 10 im unteren Diagramm derjenige Verlauf der Fehlerspannungswerte $U_F$ angegeben, der direkt an dem tatsächlichen Fehlerort gemessen werden könnte.

Da der tatsächliche Fehlerort zunächst jedoch unbekannt ist, muss derjenige Wert für x gefunden werden, bei dem die beste Übereinstimmung der beiden Fehlerspannungsverläufe $U_{F,1}$, $U_{F,2}$ vorliegt.

Mit anderen Worten muss zunächst einerseits von dem ersten Leitungsende für einen ersten fiktiven bzw. angenommenen Fehlerort der Verlauf der Fehlerspannungswerte $U_{F,1}$ entsprechend Gleichung (32) und andererseits von dem zweiten Leitungsende für denselben fiktiven bzw. angenommenen Fehlerort der Verlauf der Fehlerspannungswerte $U_{F,2}$ entsprechend Gleichung (33) bestimmt werden. Sollten beide Verläufe übereinstimmen, würde der erste fiktive Fehlerort mit dem tatsächlichen Fehlerort übereinstimmen. Sofern keine Übereinstimmung vorliegt, muss dieselbe Vorgehensweise für einen zweiten fiktiven Fehlerort durchgeführt werden. Die Vorgehensweise wird so lange fortgesetzt, bis bei einem fiktiven Fehlerort eine Übereinstimmung der beiden Fehlerspannungsverläufe $U_{F,1}$, $U_{F,2}$ festgestellt wird; dieser fiktive Fehlerort entspricht dann dem tatsächlichen Fehlerort.

Eine solche manuelle Suche nach dem Fehlerort ist vergleichsweise aufwendig; außerdem wird in der Realität aufgrund von Mess- und Rechenungenauigkeiten sowie der verwendeten Leitungsparameter in der Regel keine exakte Identität der Verläufe der Fehlerspannungswerte $U_{F,1}$, $U_{F,2}$ zu erwarten sein.

Die soeben beschriebene Vorgehensweise kann daher vorteilhaft durch ein mathematisches Optimierungsverfahren ersetzt werden, bei dem eine Zielfunktion erstellt wird, mit der die beste Übereinstimmung der beiden Fehlerspannungsverläufe abhängig vom Fehlerort ermittelt werden kann. Als Parameter für die Zielfunktion kann die Entfernung x des Fehlerorts vom ersten Leitungsende 11a verwendet werden. Für den tatsächlichen Fehlerort gilt also:

$$\left(U_{F,1}(x, j\omega)e^{-\gamma(j\omega)x} - U_{F,2}(l-x, j\omega)e^{-\gamma(j\omega)(l-x)}\right) \approx 0 \qquad (34)$$

Um die Bedingung Gleichung (34) zu erfüllen, lassen sich verschiedene Zielfunktionen erstellen. Eine mögliche Zielfunktion $ZF_1$, bei der zur Optimierung eine Minimierung stattfindet ist nachfolgend durch Gleichung (35) angegeben:

$$ZF_1 = \min\int_\omega \left(U_{F,1}(x, j\omega)e^{-\gamma(j\omega)x} - U_{F,2}(l-x, j\omega)e^{-\gamma(j\omega)(l-x)}\right)^2 \qquad (35)$$

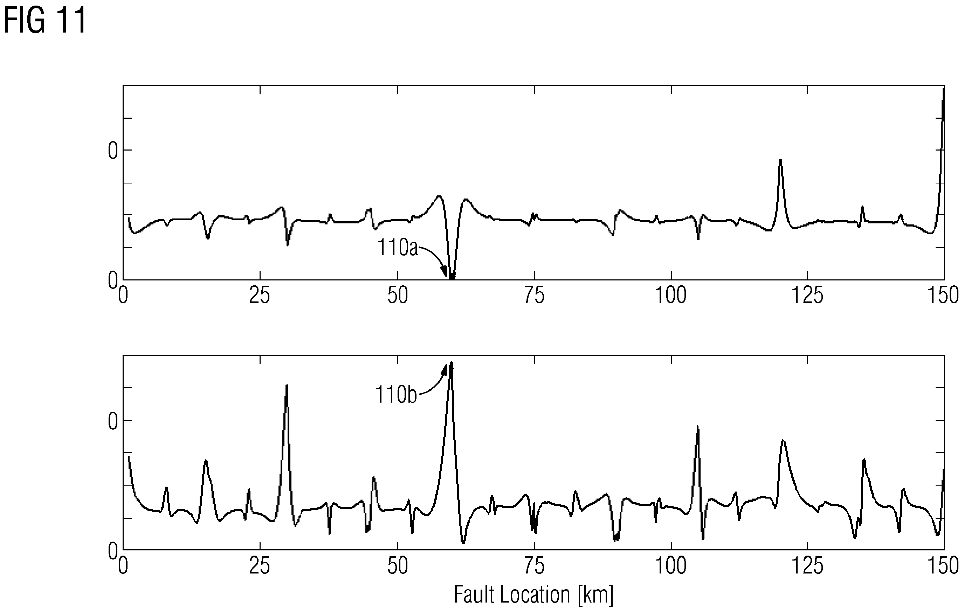

Der Verlauf der Zielfunktion $ZF_1$ ist beispielhaft im oberen Diagramm in Figur 11 für den Fall eines einpoligen Fehlers mit einer Entfernung x=60km vom ersten Leitungsende 11a dargestellt. Die Leitungslänge betrage in diesem Fall 150km, so dass sich im Diagramm ein Minimum 110a für eine Entfernung des Fehlerortes vom ersten Leitungsende 11a bei x=60km bzw. vom zweiten Leitungsende 11b bei (l-x)=90km ergibt.

Eine andere mögliche Zielfunktion $ZF_2$, bei der zur Optimierung eine Maximierung stattfindet ist nachfolgend durch Gleichung (36) angegeben:

$$ZF_2 = \max\int_\omega \left(U_{F,1}(x, j\omega)e^{-\gamma(j\omega)x} \cdot \left(U_{F,2}(l-x, j\omega)e^{-\gamma(j\omega)(l-x)}\right)^*\right) \qquad (36)$$

Hierbei wird durch den Stern * der konjugiert komplexe Ausdruck bezeichnet. Der Verlauf der Zielfunktion $ZF_2$ ist beispielhaft im unteren Diagramm in Figur 11 ebenfalls für den Fall eines einpoligen Fehlers mit einer Entfernung x=60km vom ersten Leitungsende 11a dargestellt. Im Diagramm ergibt sich ein Maximum 110b für eine Entfernung des Fehlerortes vom ersten Leitungsende 11a bei x=60km bzw. vom zweiten Leitungsende 11b bei (l-x)=90km.

Die Gleichungen (35) und (36) stellen beispielhafte Zielfunktionen dar, die einem Minimierungs- bzw. Maximierungsprozess auferlegt werden müssen. Dies kann beispielsweise durch ein mathematisches iteratives Verfahren gelöst werden. Den Minimierungs- bzw. Maximierungsprozess kann man sowohl im Frequenz- als auch im Zeitbereich durchführen, wobei die Berechnung der Fehlerspannungsverläufe bevorzugt im Frequenzbereich stattfindet. Da in digitalen Geräten wie den Einrichtungen 15a, 15b üblicherweise mit diskreten Werten gearbeitet wird, können die Verfahren entsprechend dieser Anforderung angepasst werden.

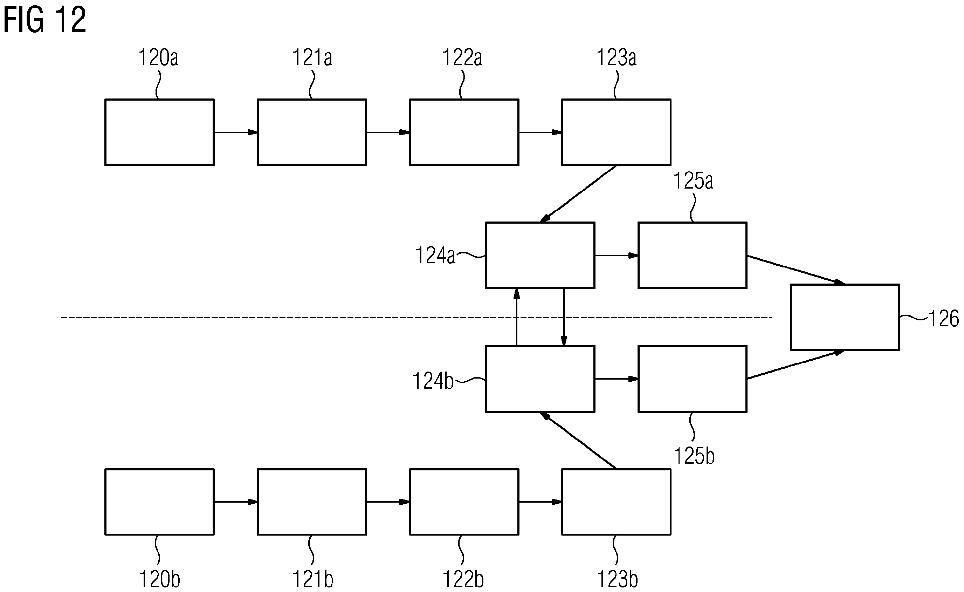

Figur 12 zeigt abschließend ein schematisches Ablaufdiagramm eines Ausführungsbeispiels eines Verfahrens zur Ermittlung eines Fehlerortes. Dabei finden die Verfahrensschritte oberhalb der gestrichelten Linie in der Einrichtung 15a am ersten Leitungsende 11a, diejenigen unterhalb der gestrichelten Linie in der Einrichtung 15b am zweiten Leitungsende 11b (vgl. Figur 1) statt.

Mit den Einrichtungen 15a, 15b an beiden Leitungsenden werden in Schritten 120a und 120b jeweils die lokalen Ströme und Spannungen gemessen und entsprechende Strom- und Spannungsmesswerte erzeugt. Diese Messwerte liegen als Abtastwerte der Strom- und Spannungssignale der Leitung 11 vor. Ein Beispiel für die erfassten Strom- und Spannungsmesswerte ist in Figur 4 ersichtlich.

Damit nur die hochfrequenten transienten Anteile (Wanderwellen) der jeweiligen Strom- bzw. Spannungsmesswerte erfasst werden, findet in Schritten 121a und 121b jeweils eine Filterung (z.B. durch einen Bandpassfilter) statt. Durch die Wahl der Eckfrequenzen z.B. des Bandpassfilters kann das Verfahren an die Eigenschaften der Wandler 13a, 13b und 14a, 14b angepasst werden. Stellen diese Wandler nur eine mittlere Bandbreite, z.B. nur bis 10kHz, zur Verfügung, dann müssen die Filter die Bandbreite der Signale auf die Bandbreite der Wandler begrenzen. Je nach Phasenfehler der eingesetzten Wandler ist dann mit einer etwas geringeren Messgenauigkeit zu rechnen. Können die Wandler eine höhere Bandbreite, z.B. bis 500kHz, bereitstellen, dann sollten die Filter entsprechend dimensioniert werden.

In den Schritten 121a, 121b werden gefilterte Strom- und Spannungswerte erzeugt, wie sie beispielhaft in Figur 5 gezeigt sind. Eine beispielhafte Übertragungscharakteristik eines geeigneten Filters ist in Figur 3 gezeigt.

Die jeweiligen Wanderwellen werden in Schritten 122a und 122b jeweils durch eine Transformation (z.B. Clarke-Transformation) behandelt, z.B. um die phasenbezogenen Anteile zu entkoppeln. Dabei werden transformierte Strom- und Spannungswerte erzeugt, wie sie beispielhaft in Figur 6 gezeigt sind.

Um das Fehlerortungsverfahren nur bei Bedarf, d.h. im Fehlerfall, zu starten und/oder um das Messfenster für die Auswertung richtig zu positionieren, kann zudem pro Seite jeweils in Schritten 123a und 123b ein transienter Sprung ermittelt werden, der z.B. als Trigger für die Messfensterpositionierung eingesetzt wird. Die Länge des Messfensters sollte bevorzugt mindestens das Doppelte der Propagationszeit der Wanderwelle in der ausgewählten Modalkomponente betragen. Die Sprungerkennung kann hinsichtlich der transformierten oder der gefilterten Strom- und Spannungswerte oder auch hinsichtlich der ursprünglichen Strom- und Spannungsmesswerte stattfinden.

In Schritten 124a und 124b findet eine Überführung der transformierten Strom- und Spannungswerte in den Frequenzbereich statt. Dies erfolgt bevorzugt mittels einer Fast Fourier Transformation (FFT) bzw. Discrete Fourier Transformation (DFT).

Wie durch die Pfeile zwischen den Blöcken der Schritte 124a und 124b angedeutet, werden die sich ergebenden Werte im Frequenzbereich zwischen den Einrichtungen 15a und 15b (vgl. Figur 1) ausgetauscht. Dies erfolgt über die Kommunikationsverbindung 16.

Mit den eigenen Werten und den Werten vom jeweils anderen Leitungsende führen die Einrichtungen 15a und 15b dann in Schritten 125a und 125b jeweils eine Fehlerortsuche mittels Optimierung einer Zielfunktion wie oben beschrieben aus. Dabei können in Schritten 125a und 125b beispielsweise die Zielfunktionen gemäß Gleichungen (35) oder (36) verarbeitet werden. Wie oben beschrieben wird dabei ein fiktiver Fehlerort gesucht, für den die Zielfunktion ein Minimum bzw. ein Maximum hat. Dieser fiktive Fehlerort wird dann als tatsächlicher Fehlerort übernommen.

In Schritt 126 wird dann der ermittelte Fehlerort ausgegeben. Gemäß Figur 12 findet dies in einem gemeinsamen Ausgabeschritt statt. Stattdessen kann auch eine separate Ausgabe durch jede der beiden Einrichtungen 15a bzw. 15b erfolgen.

Die Einrichtungen 15a und 15b besitzen üblicherweise eine Recheneinrichtung, in der die Schritte 120a/b bis 126 durchgeführt werden. Dabei kann es sich z.B. um einen Mikroprozessor handeln, der auf eine entsprechende Gerätesoftware zugreift, die sich in einem Speicher der jeweiligen Einrichtung befindet. Alternativ kann es sich auch um einen Rechenbaustein mit hardwarebestimmter Programmierung handeln, z.B. einen ASIC oder FPGA.

In Figuren 1 und 12 wurde ein System zum Ermitteln eines Fehlerortes gezeigt, bei dem der Fehlerort mit zwei Einrichtungen 15a und 15b ermittelt wird, die sich jeweils an einem Leitungsende 11a bzw. 11b befinden. Stattdessen kann auch eine zentrale Einrichtung vorgesehen sein, der die Strom- und Spannungsmesswerte von den Leitungsenden zugeführt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln des Fehlerortes (F) eines Fehlers auf einer Leitung (11) eines elektrischen Energieversorgungsnetzes, bei dem

   - an einem ersten Leitungsende (11a) der Leitung (11) erste Strom- und Spannungswerte gemessen werden;
   - an einem zweiten Leitungsende (11b) der Leitung (11) zweite Strom- und Spannungswerte gemessen werden; und
   - unter Verwendung der ersten und zweiten Strom- und Spannungswerte nach dem Auftreten eines Fehlers auf der Leitung (11) dessen Fehlerort (F) bestimmt wird;
   **dadurch gekennzeichnet, dass**
   - die an den Leitungsenden (11a, 11b) gemessenen Strom- und Spannungswerte einer Filterung unterzogen werden, wobei erste und zweite gefilterte Strom- und Spannungswerte gebildet werden, die einen ausgewählten Frequenzbereich der gemessenen Strom- und Spannungswerte angeben;
   - unter Verwendung der ersten gefilterten Strom- und Spannungswerte und eines Ausbreitungsmodells für Wanderwellen auf der Leitung (11) ein an einem fiktiven Fehlerort auf der Leitung (11) vorliegender zeitlicher Verlauf von ersten fiktiven Fehlerspannungswerten bestimmt wird;
   - unter Verwendung der zweiten gefilterten Strom- und Spannungswerte und des Ausbreitungsmodells für Wanderwellen auf der Leitung (11) ein an dem fiktiven Fehlerort auf der Leitung (11) vorliegender zeitlicher Verlauf von zweiten fiktiven Fehlerspannungswerten bestimmt wird;
   - ein fiktiver Fehlerort auf der Leitung (11) ermittelt wird, für den der Verlauf der ersten fiktiven Fehlerspannungswerte mit dem Verlauf der zweiten fiktiven Fehlerspannungswerte am stärksten übereinstimmt, wobei die Ermittlung des fiktiven Fehlerortes auf der Leitung (11), für den der Verlauf der ersten fiktiven Fehlerspannungswerte mit dem Verlauf der zweiten fiktiven Fehlerspannungswerte am stärksten übereinstimmt, mittels eines Optimierungsverfahrens erfolgt, wobei der fiktive Fehlerort als Optimierungsgröße einer Zielfunktion des Optimierungsverfahrens verwendet wird; und
   - der ermittelte fiktive Fehlerort als Fehlerort (F) des Fehlers auf der Leitung (11) verwendet wird.

2. Verfahren nach Anspruch 1,
   **dadurch gekennzeichnet, dass**

   - das Optimierungsverfahren ein iteratives Optimierungsverfahren ist.

3. Verfahren nach Anspruch 1 oder 2,
   **dadurch gekennzeichnet, dass**

   - mit der Zielfunktion derjenige fiktive Fehlerort bestimmt wird, für den ein Minimum der Differenz des Verlaufes der ersten fiktiven Fehlerspannungswerte und des Verlaufs der zweiten fiktiven Fehlerspannungswerte vorliegt.

4. Verfahren nach einem der vorangehenden Ansprüche, **dadurch gekennzeichnet, dass**

   - mit der Zielfunktion derjenige fiktive Fehlerort bestimmt wird, für den ein Maximum des Produkts des Verlaufes der ersten fiktiven Fehlerspannungswerte und des konjugiert komplexen Verlaufs der zweiten fiktiven Fehlerspannungswerte vorliegt.

5. Verfahren nach einem der vorangehenden Ansprüche, **dadurch gekennzeichnet, dass**

   - der ausgewählte Frequenzbereich hochfrequente transiente Anteile oder bandbegrenzte transiente Anteile der gemessenen Strom- und Spannungswerte umfasst.

6. Verfahren nach einem der vorangehenden Ansprüche, **dadurch gekennzeichnet, dass**

   - bei einem mehrphasigen elektrischen Energieversorgungsnetz hinsichtlich der ersten und zweiten gefilterten Strom- und Spannungswerten eine mathematische Transformation zur Entkopplung der einzelnen Phasenanteile durchgeführt wird, wobei erste und zweite transformierte Strom- und Spannungswerte gebildet werden; und
   - die fiktiven ersten und zweiten Fehlerspannungswerte unter Verwendung der ersten und zweiten transformierten Strom- und Spannungswerte bestimmt werden.

7. Verfahren nach einem der vorangehenden Ansprüche, **dadurch gekennzeichnet, dass**

- die Ermittlung des Fehlerortes (F) dann vorgenommen wird, wenn im Verlauf der der ersten Strom- und Spannungswerte oder davon abgeleiteten Werten und/oder im Verlauf der zweiten Strom- und Spannungswerte oder davon abgeleiteten Werten ein Sprung festgestellt worden ist, der eine vorgegebene Schwelle übersteigt.

8. Verfahren nach einem der vorangehenden Ansprüche, **dadurch gekennzeichnet, dass**

- die Ermittlung des Fehlerortes (F) mittels einer dazu eingerichteten Einrichtung (15a, 15b) erfolgt; und
- der ermittelte Fehlerort (F) von der Einrichtung (15a, 15b) ausgegeben wird.

9. Verfahren nach einem der Ansprüche 1 bis 7, **dadurch gekennzeichnet, dass**

- mittels je einer Einrichtung (15a, 15b) an jedem der Leitungsenden (11a, 11b) die Ermittlung des Fehlerortes (F) erfolgt; und
- die mit den Einrichtungen (15a, 15b) ermittelten Fehlerorte (F) von den Einrichtungen (15a, 15b) ausgegeben werden.

10. Einrichtung (15a, 15b) zum Ermitteln des Fehlerortes (F) eines Fehlers auf einer Leitung (11) eines elektrischen Energieversorgungsnetzes, mit

- einer Recheneinrichtung, die dazu eingerichtet ist, unter Verwendung von an einem ersten Leitungsende (11a) der Leitung (11) gemessenen ersten Strom- und Spannungswerten und an einem zweiten Leitungsende (11b) der Leitung (11) gemessenen zweiten Strom- und Spannungswerten nach dem Auftreten eines Fehlers auf der Leitung dessen Fehlerort (F) zu bestimmen;
**dadurch gekennzeichnet, dass**
- die Einrichtung (15a, 15b) einen Filter umfasst, der dazu eingerichtet ist, die an den Leitungsenden (11a, 11b) gemessenen Strom- und Spannungswerte einer Filterung zu unterziehen, wobei erste und zweite gefilterte Strom- und Spannungswerte gebildet werden, die einen ausgewählten Frequenzbereich der gemessenen Strom- und Spannungswerte angeben;
- die Recheneinrichtung dazu eingerichtet ist, unter Verwendung der ersten gefilterten Strom- und Spannungswerte und eines Ausbreitungsmodells für Wanderwellen auf der Leitung (11) einen an einem fiktiven Fehlerort auf der Leitung (11) vorliegenden zeitlichen Verlauf von ersten fiktiven Fehlerspannungswerten zu bestimmen;
- die Recheneinrichtung dazu eingerichtet ist, unter Verwendung der zweiten gefilterten Strom- und Spannungswerte und des Ausbreitungsmodells für Wanderwellen auf der Leitung (11) einen an dem fiktiven Fehlerort auf der Leitung (11) vorliegenden zeitlichen Verlauf von zweiten fiktiven Fehlerspannungswerten zu bestimmen; und
- die Recheneinrichtung dazu eingerichtet ist, einen fiktiven Fehlerort auf der Leitung (11) zu ermitteln, für den der Verlauf der ersten fiktiven Fehlerspannungswerte mit dem Verlauf der zweiten fiktiven Fehlerspannungswerte am stärksten übereinstimmt, wobei die Ermittlung des fiktiven Fehlerortes auf der Leitung (11), für den der Verlauf der ersten fiktiven Fehlerspannungswerte mit dem Verlauf der zweiten fiktiven Fehlerspannungswerte am stärksten übereinstimmt, mittels eines Optimierungsverfahrens erfolgt, wobei der fiktive Fehlerort als Optimierungsgröße einer Zielfunktion des Optimierungsverfahrens verwendet wird, und den ermittelten fiktiven Fehlerort als Fehlerort (F) des Fehlers auf der Leitung (11) anzugeben.

11. Einrichtung (15a, 15b) nach Anspruch 10, **dadurch gekennzeichnet, dass**

- die Einrichtung (15a, 15b) ein elektrisches Schutzgerät ist.

12. Einrichtung (15a, 15b) nach Anspruch 10, **dadurch gekennzeichnet, dass**

- die Einrichtung (15a, 15b) eine separate Fehlerlokalisier-Einrichtung ist.

13. System (10) zum Ermitteln des Fehlerortes (F) eines Fehlers auf einer Leitung (11) eines elektrischen Energieversorgungsnetzes, mit zwei nach einem der Ansprüche 10 bis 12 ausgebildeten Einrichtungen (15a, 15b), die mit einer Kommunikationsverbindung (16) zum Datenaustausch miteinander in Verbindung stehen.

**Claims**

1. Method for determining the fault location (F) of a fault on a line (11) of an electrical energy supply network, in which

   - first current and voltage values are measured at a first line end (11a) of the line (11);
   - second current and voltage values are measured at a second line end (11b) of the line (11); and
   - the fault location (F) of a fault is defined using the first and second current and voltage values following the occurrence of said fault on the line (11);
   **characterized in that**
   - the current and voltage values measured at the line ends (11a, 11b) are subjected to a filtering, wherein first and second filtered current and voltage values are formed which indicate a selected frequency range of the measured current and voltage values;
   - a temporal characteristic of first fictitious fault voltage values present at a fictitious fault location on the line (11) is defined using the first filtered current and voltage values and a propagation model for travelling waves on the line (11);
   - a temporal characteristic of second fictitious fault voltage values present at the fictitious fault location on the line (11) is defined using the second filtered current and voltage values and the propagation model for travelling waves on the line (11);
   - a fictitious fault location on the line (11) is determined for which the characteristic of the first fictitious fault voltage values corresponds most closely to the characteristic of the second fictitious fault voltage values, wherein the fictitious fault location on the line (11) for which the characteristic of the first fictitious fault voltage values corresponds most closely to the characteristic of the second fictitious fault voltage values is determined by means of an optimization method, wherein the fictitious fault location is used as an optimization parameter of a target function of the optimization method; and
   - the determined fictitious fault location is used as the fault location (F) of the fault on the line (11).

2. Method according to Claim 1,
   **characterized in that**

   - the optimization method is an iterative optimization method.

3. Method according to Claim 1 or 2,
   **characterized in that**

   - the fictitious fault location for which a minimum of the difference between the characteristic of the first fictitious fault voltage values and the characteristic of the second fictitious fault voltage values is present is defined with the target function.

4. Method according to one of the preceding claims, **characterized in that**

   - the fictitious fault location for which a maximum of the product of the characteristic of the first fictitious fault voltage values and the complex-conjugate characteristic of the second fictitious fault voltage values is present is defined with the target function.

5. Method according to one of the preceding claims, **characterized in that**

   - the selected frequency range comprises high-frequency transient components or band-limited transient components of the measured current and voltage values.

6. Method according to one of the preceding claims,
   **characterized in that**

   - in the case of a multiphase electrical energy supply network, in respect of the first and second filtered current and voltage values, a mathematical transformation is performed to decouple the individual phase components, wherein first and second transformed current and voltage values are formed; and
   - the fictitious first and second fault voltage values are defined using the first and second transformed current and voltage values.

7. Method according to one of the preceding claims,
   **characterized in that**

   - the determination of the fault location (F) is carried out if a jump which exceeds a predefined threshold has been identified in the characteristic of the first current and voltage values or values derived therefrom and/or in the characteristic of the second current and voltage values or values derived therefrom.

8. Method according to one of the preceding claims,
   **characterized in that**

   - the fault location (F) is determined by means of a device (15a, 15b) configured for this purpose; and
   - the determined fault location (F) is output by the device (15a, 15b).

9. Method according to one of Claims 1 to 7,
   **characterized in that**

   - the fault location (F) is determined in each case by means of a respective device (15a, 15b) at each of the line ends (11a, 11b); and
   - the fault locations (F) determined with the devices (15a, 15b) are output by the devices (15a, 15b).

10. Device (15a, 15b) for determining the fault location (F) of a fault on a line (11) of an electrical energy supply network, with

    - a processing device which is configured to determine the fault location (F) of a fault using first current and voltage values measured at a first line end (11a) of the line (11) and second current and voltage values measured at a second line end (11b) of the line (11) following the occurrence of said fault on the line;
    **characterized in that**
    - the device (15a, 15b) comprises a filter which is configured to subject the current and voltage values measured at the line ends (11a, 11b) to a filtering, wherein first and second filtered current and voltage values are formed which indicate a selected frequency range of the measured current and voltage values;
    - the processing device is configured to define a temporal characteristic of first fictitious fault voltage values present at a fictitious fault location on the line (11) using the first filtered current and voltage values and a propagation model for travelling waves on the line (11);
    - the processing device is configured to define a temporal characteristic of second fictitious fault voltage values present at the fictitious fault location on the line (11) using the second filtered current and voltage values and the propagation model for travelling waves on the line (11); and
    - the processing device is configured to determine a fictitious fault location on the line (11) for which the characteristic of the first fictitious fault voltage values corresponds most closely to the characteristic of the second fictitious fault voltage values, wherein the fictitious fault location on the line (11) for which the characteristic of the first fictitious fault voltage values corresponds most closely to the characteristic of the second fictitious fault voltage values is determined by means of an optimization method, wherein the fictitious fault location is used as an optimization parameter of a target function of the optimization method, and to indicate the determined fictitious fault location as the fault location (F) of the fault on the line (11).

11. Device (15a, 15b) according to Claim 10,
    **characterized in that**

    - the device (15a, 15b) is an electrical protection device.

12. Device (15a, 15b) according to Claim 10,
    **characterized in that**

    - the device (15a, 15b) is a separate fault-localizing device.

13. System (10) for determining the fault location (F) of a fault on a line (11) of an electrical energy supply network, with two devices (15a, 15b) designed according to one of Claims 10 to 12 which are interconnected via a communication connection (16) to exchange data.

**EP 3 193 420 B1**

**Revendications**

1. Procédé de détermination de l'emplacement (F) d'un défaut sur une ligne (11) d'un réseau d'alimentation en énergie électrique, dans lequel

   - on mesure des premières valeurs de courant et de tension à un premier bout (11a) de la ligne (11) ;
   - on mesure des deuxièmes valeurs de courant et de tension à un second bout (11b) de ligne (11) ; et
   - en utilisant les première et deuxième valeurs de courant et de tension, on détermine après l'apparition d'un défaut sur la ligne (11) son emplacement (F) ;
   **caractérisé en ce que**
   - on soumet les valeurs de courant et de tension mesurées aux bouts (11a, 11b) de la ligne à un filtrage, dans lequel on forme des première et deuxième valeurs filtrées de courant et de tension, qui indiquent une plage de fréquence sélectionnée des valeurs mesurées de courant et de tension ;
   - en utilisant les première valeurs filtrées de courant et de tension et un modèle de propagation d'ondes progressives sur la ligne (11), on définit une courbe, en fonction du temps, de premières valeurs fictives de tension de défaut présentes en un emplacement fictif de défaut sur la ligne (11) ;
   - en utilisant les deuxième valeurs filtrées de courant et de tension et le modèle de propagation d'ondes progressives sur la ligne (11), on définit une courbe, en fonction du temps, de deuxièmes valeurs fictives de tension de défaut présente sur la ligne (11) à l'emplacement fictif de défaut ;
   - on détermine un emplacement fictif de défaut sur la ligne (11), pour lequel la courbe des première valeurs fictives de tension de défaut coïncide très fortement avec la courbe des deuxièmes valeurs fictives de tension de défaut, dans lequel la détermination de l'emplacement fictif de défaut sur la ligne (11), pour lequel la courbe des premières valeurs fictives de tension de défaut coïncide très fortement avec la courbe des deuxièmes valeurs fictives de tension de défaut, au moyen d'un procédé d'optimisation, dans lequel on utilise l'emplacement fictif de défaut comme grandeur d'optimisation d'une fonction cible du procédé d'optimisation ; et
   - on utilise l'emplacement fictif de défaut, qui est déterminé, comme emplacement (F) du défaut sur la ligne (11).

2. Procédé suivant la revendication 1,
   **caractérisé en ce que**

   - le procédé d'optimisation est un procédé d'optimisation par itération.

3. Procédé suivant la revendication 1 ou 2,
   **caractérisé en ce qu'**

   - on définit, par la fonction cible, l'emplacement fictif de défaut pour lequel il y a un minimum de la différence entre la courbe des premières valeurs fictives de tension de défaut et la courbe des deuxièmes valeurs fictives de tension de défaut.

4. Procédé suivant l'une des revendications précédentes,
   **caractérisé en ce qu'**

   - on définit, par la fonction cible, l'emplacement fictif de défaut pour lequel il y a un maximum du produit de la courbe des premières valeurs fictives de tension de défaut par la courbe complexe conjuguée des deuxièmes valeurs fictives de tension de défaut.

5. Procédé suivant l'une des revendications précédentes,
   **caractérisé en ce que**

   - la plage de fréquence sélectionnée comprend des composantes transitoires de haute fréquence ou des composantes transitoires limitées en bande des valeurs mesurées de courant et de tension.

6. Procédé suivant l'une des revendications précédentes,
   **caractérisé en ce que**

   - pour un réseau d'alimentation en énergie électrique polyphasé, on effectue, en ce qui concerne les premières et deuxièmes valeurs filtrées de courant et de tension, une transformation mathématique de découplement des diverses composantes de phase, dans lequel on forme des premières et deuxièmes valeurs transformées de courant et de tension ; et

- on définit les premières et deuxièmes valeurs fictives de tension de défaut, en utilisant les premières et deuxièmes valeurs transformées de courant et de tension.

7. Procédé suivant l'une des revendications précédentes,
**caractérisé en ce qu'**

- on effectue la détermination de l'emplacement (F) de défaut lorsque, dans la courbe des premières valeurs de courant et de tension ou de valeurs qui s'en déduisent et/ou dans la courbe des deuxièmes valeurs de courant et de tension ou de valeurs qui s'en déduisent, il est constaté un saut, qui dépasse un seuil donné à l'avance.

8. Procédé suivant l'une des revendications précédentes, **caractérisé en ce que**

- la détermination de l'emplacement (F) du défaut s'effectue au moyen d'un dispositif (15a, 15b) conçu à cet effet ; et
- on donne l'emplacement (F) déterminé de défaut par le dispositif (15a, 15b).

9. Procédé suivant l'une des revendications 1 à 7,
**caractérisé en ce que**

- la détermination de l'emplacement (F) s'effectue au moyen de respectivement un dispositif (15a, 15b) à chaque bout (11a, 11b) de la ligne ; et
- on donne, par les dispositifs (15a, 15b), les emplacements (F) de défaut déterminés par les dispositifs (15a, 15b).

10. Dispositif (15a, 15b) de détermination de l'emplacement (F) d'un défaut sur une ligne (11) d'un réseau d'alimentation en énergie électrique, comprenant

- un dispositif informatique, qui est conçu pour définir, en utilisant des premières valeurs de courant et de tension mesurées à un premier bout (11a) de la ligne (11) et des deuxièmes valeurs de courant et de tension mesurées à un deuxième bout (11b) de la ligne (11), après l'apparition d'un défaut sur la ligne, son emplacement (F) ;
**caractérisé en ce que**
- le dispositif (15a, 15b) comprend un filtre, qui est conçu pour soumettre à un filtrage les valeurs de courant et de tension mesurées aux bouts (11a, 11b) de la ligne, dans lequel on forme des premières et deuxièmes valeurs filtrées de courant et de tension, qui indiquent une plage de fréquence sélectionnée des valeurs mesurées de courant et de tension ;
- le dispositif informatique est conçu pour définir, en utilisant les premières valeurs filtrées de courant et de tension et un modèle de propagation d'ondes progressives sur la ligne (11), une courbe, en fonction du temps, de premières valeurs fictives de tension de défaut présente en un emplacement fictif de défaut sur la ligne (11) ; et
- le dispositif informatique est conçu pour définir, en utilisant les deuxièmes valeurs filtrées de courant et de tension et le modèle de propagation d'ondes progressives sur la ligne (11), une courbe, en fonction du temps, de deuxièmes valeurs fictives de tension de défaut présente à l'emplacement fictif de défaut sur la ligne (11) ; et
- le dispositif informatique est conçu pour déterminer un emplacement fictif de défaut sur la ligne (11), pour lequel la courbe des premières valeurs fictives de tension de défaut coïncide très fortement avec la courbe des deuxièmes valeurs fictives de tension de défaut, dans lequel la détermination de l'emplacement fictif de défaut sur la ligne (11), pour lequel la courbe des premières valeurs fictives de tension de défaut coïncide très fortement avec la courbe des deuxièmes valeurs fictives de tension de défaut, est effectuée au moyen d'un procédé d'optimisation, dans lequel on utilise l'emplacement fictif de défaut comme grandeur d'optimisation d'une fonction cible du procédé d'optimisation et pour indiquer l'emplacement fictif de défaut, qui a été déterminé, comme emplacement (F) du défaut sur la ligne (11) .

11. Dispositif (15a, 15b) suivant la revendication 10,
**caractérisé en ce que**

- le dispositif (15a, 15b) est un appareil de protection électrique.

12. Dispositif (15a, 15b) suivant la revendication 10,
**caractérisé en ce que**

- le dispositif (15a, 15b) est un dispositif distinct de localisation de défaut.

13. Système (10) de détermination de l'emplacement d'un défaut (F) sur une ligne (11) d'un réseau d'alimentation en énergie électrique, comprenant deux dispositifs (15a, 15b) constitués suivant l'une des revendications 10 à 12, qui sont en liaison, pour l'échange de données entre eux, par une liaison (16) de communication.

FIG 1

FIG 2

FIG 3

EP 3 193 420 B1

FIG 4

EP 3 193 420 B1

## FIG 5

FIG 6

FIG 7

# FIG 8

EP 3 193 420 B1

FIG 9

EP 3 193 420 B1

EP 3 193 420 B1

FIG 10

FIG 11

Fault Location [km]

110a

110b

# FIG 12

**EP 3 193 420 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- WO 2012126526 A1
- US 4996624 A
- US 5929642 A
- US 20120068717 A1
- US 8655609 B2